# EUROPEAN PATENT APPLICATION

(11) **EP 2 093 702 A1**
(43) Date of publication of application: **26.08.2009**
(21) Application number: 07816884.6
(22) Date of filing: 20.11.2007
(51) Int. Cl.: G06K 19/07

(54) **CARD WITH INTERFACE CONTACT AND ITS MANUFACTURING METHOD**

(30) Priority: 24.11.2006 CN 200610144071
(71) Applicant: Beijing Watchdata System Co. Ltd., Chaoyang District, Beijing 100015 (CN)
(72) Inventor: XU, Rongjin, Beijing 100015 (CN); LI, Yong, Beijing 100015 (CN)
(74) Representative: HOFFMANN EITLE
(86) International application number: PCT/CN2007/003286
(87) International publication number: WO 2008/061450

(57) **Abstract**

A card with an interface contact and its manufacturing method includes: embedding at least two chips into a flexible board to get a module with corresponding interface contact according to the interface standard of the card, and encapsulating the module into the card base.

## Description

### BACKGROUND OF THE INVENTION

### 1. Technical Field

The present invention relates to a card with an interface contact and a manufacturing method thereof.

### 2. Description of Related Art

Nowadays, cards or memories with MMC (Multi Media Card) interface contacts or USB (Universal Serial Bus) interface contacts typically utilize costly PCBs (Printed Circuit Boards), and during the manufacturing process thereof, some steps have to be performed manually. Consequently, the production cost is relatively high and the production efficiency is relatively low.

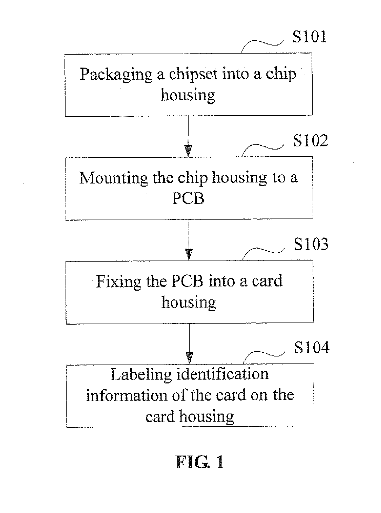

Taking a conventional card with an MMC interface contact as an example, a typical manufacturing process thereof is shown in FIG. 1, which comprises the following steps of:
Step S 101: packaging a chipset into a chip housing;
   wherein the chipset comprises at least two chips.
Step S102: mounting the chip housing to a PCB;
Step S103: fixing the PCB into a card housing;

Currently, this step is performed mostly in a self-automatic way and relies mainly on manual operations.

Step S104: labeling identification information of the card such as the product identification and serial number on the card housing.

Currently, this step can be performed manually or by use of special equipment.

As can be seen, because the conventional cards with MMC interface contacts utilize costly PCBs and some steps have to be performed manually, fabrication of the conventional cards with MMC interface contacts presents both high material cost and labor cost. Meanwhile because some steps have to be performed manually, the production efficiency is relatively low.

### BRIEF SUMMARY OF THE INVENTION

The present invention provides a card with an interface contact and a manufacturing method thereof, which are aimed to decrease the production cost of prior art cards with MMC interface contacts or USB interface contacts and to improve production efficiency of the card.

To solve this technical problem, the present invention provides a method for manufacturing a card with an interface contact, comprising the following steps of:
embedding at least two chips into a flexible board according to an interface standard of the card to form a module with a corresponding interface contact; and
packaging the module into a card base.

Further, this method may also be characterized in that: the interface standard of the card is:
either of an MMC interface standard or a USB interface standard; or
a combination of the MMC interface standard or the USB interface standard with the contact IC card interface standard.

Further, this method may also be characterized in that: if the interface standard is the combination of the MMC interface standard or the USB interface standard with the contact IC card interface standard, after the module is packaged into the card base, the contact IC card interface contact is used to write security information into the chipset.

Further, this method may also be characterized in that: the card base has a thickness that complies with the MMC interface standard or the USB interface standard.

Further, this method may also be characterized in that: the card base has a length and a width that comply with the MMC interface standard or the USB interface standard.

Further, this method may also be characterized in that: after the module is packaged into the card base, punch-cutting or cutting the card base into a shape whose length and width comply with the MMC interface standard or the USB interface standard.

Further, this method may also be characterized in that: packaging two or more modules into the card base.

Further, this method may also be characterized in that: after the module is packaged into the card base, printing the identification information of the card onto the card base.

Further, this method may also be characterized in that: embedding the chip into the flexible board through an Au wire bonding or a flip-chip bonding process.

Further, this method may also be characterized in that: after the at least two chips are embedded into the flexible board, fixing the at least two chips to the flexible board by using an encapsulating material.

Further, this method may also be characterized in that: packaging the module into the card base comprises: forming grooves in the card base, wherein a size of an outer groove is identical to the flexible board and a size of an inner groove is determined by a size of the encapsulating material; adhering the module to the card base by applying a glue or adhering a hot tape on the outer groove area.

The present invention also provides a card with an interface contact, which comprises a module with the interface contact and a card base for packaging the module, wherein:
the module comprises a flexible board whose contact surface has the interface contact, and at least two chips embedded into the flexible board.

Further, this card may also be characterized in that: the interface contact is:
either of an MMC interface contact or a USB interface contact; or
a combination of the MMC interface contact or the USB interface contact with an contact IC card interface contact.

Further, this card may also be characterized in that: the card base has a thickness, a length and a width that comply with the interface standard corresponding to the MMC interface contact or the interface standard corresponding to the USB interface contact.

Further, this card may also be characterized in that: the card comprises two or more modules.

Further, this card may also be characterized in that: the chip is embedded into the flexible board through an Au wire bonding or a flip-chip bonding process.

Further, this card may also be characterized in that: the card comprises an encapsulating material for fixing the at least two chips to the flexible board.

Further, this card may also be characterized in that: the card base comprises an outer groove having a size identical to that of the flexible board and an inner groove determined by a size of the encapsulating material.

The present invention provides the following benefits:
By using a cheap flexible board as a strap base of the chipset, the present invention decreases the material cost involved in manufacturing the card with an MMC interface contact or a USB interface contact; moreover, in the technical solution of the present invention, manually performed steps can be removed, thereby decreasing the labor cost involved in production of the card and improving the production efficiency.

### BRIEF DESCRIPTION OF THE SEVERAL VIEWS OF THE DRAWINGS

FIG. 1 is a flowchart illustrating a manufacturing process of a conventional card with an MMC interface contact;
FIG. 2 is a flowchart illustrating a manufacturing process of a card with an MMC interface contact according to the first Embodiment of the present invention;
FIG. 3 is a flowchart illustrating a manufacturing process of a card with both an MMC interface contact and a contact IC (Integrated Circuit) card interface contact according to the second Embodiment of the present invention;
FIG. 4 is a schematic view of a mounting surface of the flexible board in an example of the second Embodiment of the present invention;
FIG. 5 is a schematic view of a contact surface of the flexible board in an example of the second Embodiment;
FIG. 6 is a schematic view of a packaged card in an example of the second Embodiment; and

FIG. 7 is a schematic view of a completed card in an example of the present invention.

### DETAILED DESCRIPTION OF THE INVENTION

The key idea of the present invention is that, according to the interface standard of the card, a chipset including at least two chips is embedded into a flexible board to form a module with a corresponding interface contact, and then the module is encapsulated into a card base to form the card.

Because the card uses a cheap flexible board, the material cost involved in producing the card can be decreased; moreover, because manually performed steps can be removed during the production process, the labor cost involved in production of the card can be decreased and the production efficiency can be improved.

Hereinafter, the present invention will be further described with reference to embodiments thereof and the attached drawings.

### Embodiment 1

In this embodiment, a chipset is embedded into a flexible board according to the MMC interface standard to form a module with an MMC interface contact, and then the module is packaged into a card base to form a card complying with the MMC interface standard. The card has an interface contact complying with the MMC interface standard.

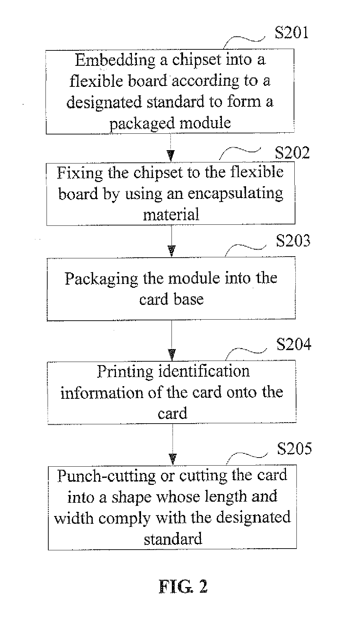

A flowchart illustrating a manufacturing process of a card with an MMC interface contact according to this embodiment is shown in FIG. 2, which comprises the following steps of:
Step S201: embedding a chipset into a flexible board according to an MMC interface standard to form a packaged module;
Depending on different MMC interface standards, this chipset comprises at least two chips.

Because, generally, the area of the chips is much smaller than that of the packaged module (e.g., a DIP (Double In-line Package) or an SOP (Small Outline Package) module), there is ample space for arranging the chips when the chipset is embedded into the flexible board. To arrange the chips, soldering pads may be designed on the mounting surface of the flexible board according to specifications of the chips to be embedded, and contacts be designed on the contact surface of the flexible board according to the MMC interface standard. Physical aspects of the contact surface of the flexible board shall fully comply with the MMC interface standard.

When the chips is to be embedded into the flexible board, the conventional Au wire bonding or flip-chip bonding process may be employed for chip bonding.

In this step, because the flexible board, which is relatively cheaper than PCBs used in the prior art, is chosen as a base of the module, cost of the card can be well decreased.

Step S202: fixing the chipset to the flexible board by using an encapsulating material (e.g., an encapsulating glue);

This step has the chips protected by the encapsulating material, so that the module is provided with reliable electrical properties.

Step S203: packaging the module into the card base, wherein the card base has a thickness that complies with the thickness requirements in the MMC interface standard;

Packaging the module into the card base comprises the following steps of:
A. forming grooves in the card base, wherein a size of an outer groove is identical to the flexible board and a size of an inner groove is determined by a size of the encapsulating material;
B. adhering the module to the card base by applying a glue or adhering a hot tape on the outer groove area.

Step S204: printing identification information of the card, such as the product identification and serial number of the card, onto the card;

As can be seen, this step labels the card in a non-manual way, which helps to decrease the labor cost and improve the production efficiency.

In implementation of this step, the card base may be provided with a length and a width that comply with the contact IC card interface standard ISO7810. When the length and width of the card base comply with the contact IC card interface standard ISO7810, if the thickness of the card base meets the requirements of the contact IC card personalizing equipment currently available, the identification information of the card may be printed onto the card by using the contact IC card personalizing equipment currently available. On the other hand, if the thickness of the card base fails to meet the requirements of the contact IC card personalizing equipment currently available, the operable thickness of the contact IC card personalizing equipment may be adjusted into, for example, the thickness of 1.4 mm of common cards with MMC interface contacts, and then the contact IC card personalizing equipment that has been adjusted is used to print the identification information of the card onto the card.

Step S205: punch-cutting or cutting the card into a shape whose length and width comply with the MMC interface standard.

In this step, the card can be cut into a shape complying with the MMC interface standard directly so that the user may use the card directly.

Alternatively, a special mould may be used to punch-cut the card into a shape complying with the MMC interface standard so that the user can use the card by simply breaking it off.

In implementation, a card base whose length and width comply with the MMC interface standard may be used directly when the card is fabricated, so that it is unnecessary to punch-cut or cut the card.

For fabrication of a card complying with the USB interface standard, the same manufacturing method as the MMC card may be adopted except that the card shall be manufactured according to the USB interface standard, so this will not be further described again.

### Embodiment 2

In this embodiment, to manufacture a card, a chipset is embedded into a flexible board according to a combination of the MMC interface standard and the contact IC card interface standard to form a module with both an MMC interface contact and a contact IC card interface contact, and then the module is encapsulated into the card base to form a card complying with both the MMC interface standard and the contact IC card interface standard. Because the card has a contact IC card interface contact, a common contact IC card personalizing equipment may be used to write personalized identification information (also known as security information) into the card for security purpose.

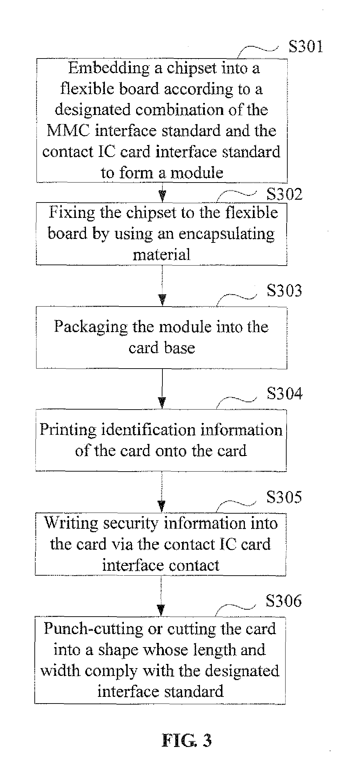

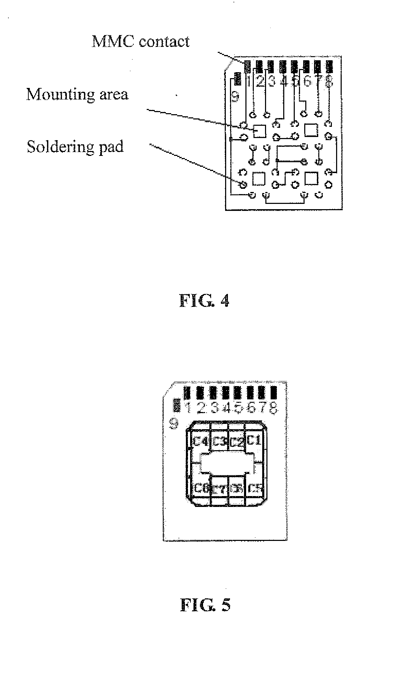

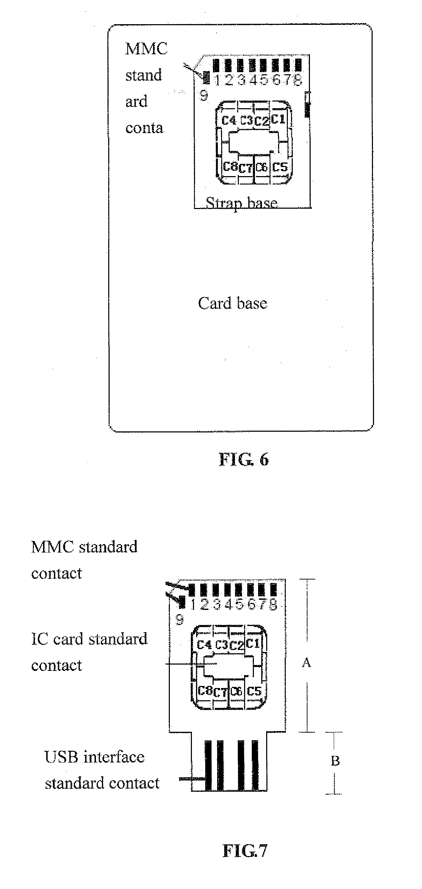

A flowchart illustrating a manufacturing process of a card with both an MMC interface contact and a contact IC card interface contact according to this embodiment is shown in FIG. 3, which comprises the following steps of:
Step S301: embedding a chipset into a flexible board according to a combination of the MMC interface standard and the contact IC card interface standard to form a module with both an MMC interface contact and a contact IC card interface contact.
   In an example of this embodiment, as shown in FIG. 4, the mounting surface of the flexible board is designed with mounting regions and soldering pads according to specifications of the chips to be embedded; and as shown in FIG. 5. the contact surface of the flexible board comprises nine contacts 1-9 complying with the MMC interface standard and eight contacts C1-C8 whose locations and sizes comply with the contact IC card interface standard ISO7816-2. Physical aspects of the contact surface fully comply with the MMC interface standard and the contact IC card interface standard.
Step S302: fixing the chipset to the flexible board by using an encapsulating material;
Step S303: packaging the module into the card base, wherein the card base has a thickness complying with the thickness requirement of the MMC interface standard;
   In this example, after the module is packaged into the card base, the packaged card is as shown in FIG. 6.
Step S304: printing identification information of the card, such as the product identification and serial number of the card, onto the card;
Step S305: writing security information into the card via the contact IC card interface contact;
   In this embodiment, Steps 304 and 305 need not to follow a specific order, and can both be implemented by a contact IC card personalizing equipment that is currently available or has been adjusted in operable thickness.

This step can improve security of the card in a simple but effective way.

Step S306: punch-cutting or cutting the card into a shape whose length and width comply with the MMC interface standard.

For fabrication of a card with both a USB interface contact and a contact IC card interface contact, the same manufacturing method as the card with both an MMC interface contact and a contact IC card interface contact may be adopted except that the card shall be manufactured according to the USB interface standard and the contact IC card interface standard, so this will not be further described again.

Conceivably, a plurality of chipsets may be embedded into a single flexible board according to different interface standards, and then flexible board be packaged into the card base. Also, a plurality of flexible boards may be packaged into a single card base. For example, in an example of this invention, a completed card is as shown in FIG. 7. To manufacture this card, a chipset is embedded into a flexible board according to a combination of the MMC interface standard and the IC card interface standard to form a first module, and another chipset is embedded into another flexible board according to the USB interface standard to form a second module. Then, a card base having a shape as shown in FIG. 7 is chosen,
wherein a portion A of the card base has a thickness, a length and a width complying with the MMC interface standard while a portion B of the card base has a thickness, a length and a width complying with the USB interface standard. Afterwards, the first module is packaged into the portion A of the card base and the second module is packaged into the portion B of the card base to form the card. The resulting card may be used for many purposes.

In an embodiment of the present invention, a card with an interface contact comprises a module with the interface contact and a card base for packaging the module, wherein:
the module comprises a flexible board whose contact surface has the interface contact, and at least two chips embedded into the flexible board.

The interface contact may be:
either of an MMC interface contact or a USB interface contact; or
a combination of the MMC interface contact or the USB interface contact with an contact IC card interface contact.

The card base has a thickness, a length and a width that comply with the interface standard corresponding to the MMC interface contact or the interface standard corresponding to the USB interface contact.

The card may comprise two or more modules.

The chip of the card may be embedded into the flexible board through an Au wire bonding or a flip-chip bonding process.

The card may comprise an encapsulating material for fixing the at least two chips to the flexible board.

The card base of the card may comprise an outer groove having a size identical to that of the flexible board and an inner groove determined by a size of the encapsulating material.

Obviously, various modifications and variations may be made to the present invention by those of ordinary skill in the art without departing from the spirit and scope of the present invention. Accordingly, the present invention intends to encompass such modifications and variations in case they still fall within the scope of the claims of the present invention and their technical equivalents.

## Claims

1. A method for manufacturing a card with an interface contact, being
**characterized in that** it comprises the following steps of:
embedding at least two chips into a flexible board according to an interface standard of the card to form a module with a corresponding interface contact; and
packaging the module into a card base.

2. The method as claimed in Claim 1, being **characterized in that** the interface
standard of the card is:
either of an MMC interface standard or a USB interface standard; or
a combination of the MMC interface standard or the USB interface standard with a contact IC card interface standard.

3. The method as claimed in Claim 2, being **characterized in that**: if the interface standard is the combination of the MMC interface standard or the USB interface standard with the contact IC card interface standard, then after the module is packaged into the card base, the contact IC card interface contact is used to write security information into the chips.

4. The method as claimed in Claim 2, being **characterized in that**: the card base has a thickness that complies with the MMC interface standard or the USB interface standard.

5. The method as claimed in Claim 4, being **characterized in that**: the card base has a length and a width that comply with the MMC interface standard or the USB interface standard.

6. The method as claimed in Claim 4, being **characterized in that**: after the module is packaged into the card base, punch-cutting or cutting the card base into a shape whose length and width comply with the MMC interface standard or the USB interface standard.

7. The method as claimed in Claim 1, being **characterized in that**: packaging two or more modules into the card base.

8. The method as claimed in Claim 1, being **characterized in that**: after the module is packaged into the card base, printing the identification information of the card onto the card base.

9. The method as claimed in Claim 1, being **characterized in that**: embedding the chip into the flexible board through an Au wire bonding or a flip-chip bonding process.

10. The method as claimed in Claim 1, being **characterized in that**: after the at least two chips are embedded into the flexible board, fixing the at least two chips to the flexible board by using an encapsulating material.

11. The method as claimed in Claim 1, being **characterized in that**: packaging the module into the card base comprises: forming grooves in the card base, wherein a size of an outer groove is identical to the flexible board and a size of an inner groove is determined by a size of the encapsulating material; adhering the module to the card base by applying a glue or adhering a hot tape on the outer groove area.

12. A card with an interface contact, being **characterized in that** it comprises a module with the interface contact and a card base for packaging the module, wherein:
the module comprises a flexible board whose contact surface has the interface contact, and at least two chips embedded into the flexible board.

13. The card as claimed in Claim 12, being **characterized in that** the interface contact is:
either of an MMC interface contact or a USB interface contact; or
a combination of the MMC interface contact or the USB interface contact with an contact IC card interface contact.

14. The card as claimed in Claim 13, being **characterized in that**: the card base has a thickness, a length and a width that comply with the interface standard corresponding to the MMC interface contact or the interface standard corresponding to the USB interface contact.

15. The card as claimed in Claim 12, being **characterized in that**: the card comprises two or more modules.

16. The card as claimed in Claim 12, being **characterized in that**: the chip is embedded into the flexible board through an Au wire bonding or a flip-chip bonding process.

17. The card as claimed in Claim 12, being **characterized in that**: the card comprises an encapsulating material for fixing the at least two chips to the flexible board.

18. The card as claimed in Claim 12 or 17, being **characterized in that**: the card base comprises an outer groove having a size identical to that of the flexible board and an inner groove determined by a size of the encapsulating material.
